(19) **Europäisches Patentamt / European Patent Office / Office européen des brevets**

(11) **EP 4 618 361 A1**

(12) **EUROPEAN PATENT APPLICATION**

(43) Date of publication:
**17.09.2025 Bulletin 2025/38**

(21) Application number: **24163856.8**

(22) Date of filing: **15.03.2024**

(51) International Patent Classification (IPC):
*H02J 7/00* (2006.01)    *G01R 31/3835* (2019.01)
*G01R 31/388* (2019.01)    *G01R 31/396* (2019.01)
*H01M 10/42* (2006.01)

(52) Cooperative Patent Classification (CPC):
**H02J 7/0048; G01R 31/3835; G01R 31/388;
G01R 31/396; H01M 10/4207; H01M 10/482;**
H02J 7/0016

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **TWAICE Technologies GmbH
80807 München (DE)**

(72) Inventors:
- **FORSTER, Max**
  **80689 München (DE)**
- **BERG, Philipp**
  **81827 München (DE)**

(74) Representative: **Kraus & Lederer PartGmbB
Thomas-Wimmer-Ring 15
80539 München (DE)**

(54) **CELL IMBALANCES IN RECHARGABLE BATTERIES**

(57)    Multiple samples each including e.g., voltage or state of charge values are obtained. Then, at least one analysis is performed, each of the at least one analysis being based on a respective at least one evolution (210, 211) of a respective at least one characteristic (220, 260, 261, 262, 270, 272) of the one or more values. Based on a result of the at least one analysis, at least one indicator associated with a cell imbalance of battery cells of the battery units (141, 142, 143, 145, 146, 147) is determined. For instance, a root cause of the cell imbalance may be determined.

# FIG. 2

**3005** OBTAIN VOLTAGE SAMPLES

**3010** ASSOCIATE EACH VOLTAGE SAMPLE WITH OPERATIONAL MODE

**3015** PERFORM ONE OR MORE ANALYSES

**3020** DETERMINE IMBALANCE INDICATOR

**3025** CONTROL

EP 4 618 361 A1

**Description**

TECHNICAL FIELD

Various examples of the disclosure concern detection of state of charge and/or voltage imbalances in a battery. Various examples specifically concern determination of a root cause of such imbalances.

BACKGROUND

Batteries oftentimes include many rechargeable battery cells. A battery cell comprises an anode, a cathode, and an electrolyte. Multiple of these battery cells are connected in series, to provide the desired voltage. Imbalances of the state of charge (SOC) and/or the voltage (cell imbalances) of the battery cells of the battery can occur. Such imbalances can result in an over-discharge and/or over-charge of individual battery cells. Over-discharge and/or over-charge can damage the cell, e.g., by copper dissolution at the anode and/or dendrite formation, i.e., growth of crystals reducing the amount of electrolyte. Thus, it is important to detect imbalances. While cell imbalances occur in various types of battery cells having various cell chemistries, cell imbalances occur particularly often in Lithium Iron Phosphate (LFP) battery cells. These LFP battery cells are widely used in battery electric storage systems (BESS), e.g., coupled to the electric grid.

Oftentimes, battery management systems (BMS) are configured to sense voltages of battery cells or sets of battery cells. Based on such voltage sensing, the BMS executes a balancing protocol, e.g., using by enabling a by-pass for some battery cells or sets of battery cells or otherwise transferring energy in-between the battery cells or sets of battery cells. An example is disclosed in US 2012/0139547 A1. It has been found that despite modern BMS executing a balancing protocol, sometimes nonetheless imbalances of the voltage and/or of the SOC can occur. This has the potential to damage the battery.

Furthermore, the balancing protocol of the BMS may limit charging or discharging to a certain threshold SOC to avoid over-charging and over-discharging. This can either accelerate ageing or degrade the operational characteristics of the battery.

US 11,513,164 B2 discloses determining a cell voltage difference based on an actual cell voltage difference measured for a battery pack. This technique requires additional knowledge on an expected cell voltage difference that depends on operating condition parameters. Accordingly, this technique is not easily transferable between different types of batteries, e.g., employing different cell chemistries.

SUMMARY

Accordingly, a need exists for advanced techniques of detecting imbalances amongst battery cells of a battery. A need exists for advanced techniques that mitigate or overcome at least some of the above-identified restrictions or drawbacks. Furthermore, a need exists for revealing a root cause of a cell imbalance.

This need is met by the features of the independent claims. The features of the dependent claims define embodiments.

A method includes obtaining multiple samples. Each sample of the multiple samples includes one or more values acquired by a battery management system of a battery. The one or more values are acquired based on voltage sensing at multiple battery units. The method further includes performing at least one analysis, each of the at least one analysis being based on a respective at least one evolution of a respective at least one characteristic of the one or more values. The method further includes, based on a result of the at least one analysis, determining at least one indicator associated with a cell imbalance of battery cells of the battery units.

A program code that is executable by at least one processor causes the at least one processor to perform such method as disclosed above.

A processing device includes at least one processor. The at least one processor is configured to load program code from a memory and to execute the program code. The at least one processor, upon loading an executing the program code, is configured to perform the method as disclosed above.

It is to be understood that the features mentioned above and those yet to be explained below may be used not only in the respective combinations indicated, but also in other combinations or in isolation without departing from the scope of the invention.

BRIEF DESCRIPTION OF THE DRAWINGS

FIG. 1 schematically illustrates a system including a battery and a processing device according to various examples.

FIG. 2 is a flowchart of a method according to various examples.

FIG. 3 illustrates the evolution, as a function of time, of a voltage spread between a minimum voltage and a maximum voltage observed across multiple battery units for which voltage sensing is enabled according to various examples.

FIG. 4 illustrates the evolution, as a function of time, of a voltage spread between a minimum voltage and a maximum voltage observed across multiple battery units for which voltage sensing is enabled according to various examples.

FIG. 5 illustrates the evolution, as a function of time, of a voltage spread between a minimum voltage and a maximum voltage observed across multiple battery units for which voltage sensing is enabled according to various examples.

FIG. 6 illustrates the evolution, as a function of state of charge, of a voltage spread between a minimum voltage and a maximum voltage observed across multiple battery units for which voltage sensing is enabled according to various examples.

FIG. 7 illustrates the evolution, as a function of time, of a voltage change rate of a minimum voltage, a maximum voltage, and an aggregate voltage observed across and for multiple units for which voltage sensing is enabled according to various examples.

FIG. 8 illustrates the evolution, as a function of time, of a voltage change rate of a minimum voltage, a maximum voltage, and an aggregate voltage observed across and for multiple units for which voltage sensing is enabled according to various examples.

FIG. 9 illustrates the evolution, as a function of time, of a voltage change rate of a minimum voltage, a maximum voltage, and an aggregate voltage observed across and for multiple units for which voltage sensing is enabled according to various examples.

FIG. 10 illustrates the evolution, as a function of time, of an indicator indicative of the battery unit experiencing the minimum voltage and of a further indicator indicative of the battery unit experiencing the maximum voltage according to various examples.

FIG. 11 illustrates the evolution, as a function of time, of an indicator indicative of the battery unit experiencing the minimum voltage and of a further indicator indicative of the battery unit experiencing the maximum voltage according to various examples.

FIG. 12 illustrates the evolution, as a function of time, of an indicator indicative of the battery unit experiencing the minimum voltage and of a further indicator indicative of the battery unit experiencing the maximum voltage according to various examples.

FIG. 13 illustrates the evolution, as a function of time, of an indicator indicative of the battery unit experiencing the minimum voltage and of a further indicator indicative of the battery unit experiencing the maximum voltage according to various examples.

FIG. 14 illustrates the evolution, as a function of time, of an indicator indicative of the battery unit experiencing the minimum voltage and of a further indicator indicative of the battery unit experiencing the maximum voltage according to various examples.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

Hereinafter, techniques for assessing an unbalance / imbalance amongst battery cells in a battery are disclosed. Imbalances can occur with respect to the voltage of battery cells and/or with respect to the SOC of the battery cells. All such imbalances are hereinafter referred to cell imbalance.

According to the disclosure, multiple samples that are acquired by a BMS of the battery are obtained at a processing device. These samples may be based on voltage sensing. This means that the BMS measures a voltage and provides a respective report. The report may include, e.g., the voltage value or may be derived therefrom. For instance, the report may include a SOC that is based on the voltage sensing. The processing device can further analyze the samples.

Voltage sensing is implemented at battery units. Each battery unit includes a voltage sensor for voltage sensing. A BMS of the battery is connected to the voltage sensor. Each voltage sensor measures the voltage of a battery unit. A battery unit may include one or more battery cells, e.g., connected in series and/or in parallel. Thus, the voltage-sensing granularity is defined by the number of battery cells included in a battery unit. Thus, in other words, the battery unit constitutes the smallest element for which a voltage value can be obtained.

Each sample is associated with a respective sampling interval. I.e., a time-sequence of samples may be obtained. For each sampling interval, the respective sample can include one or more voltage and/or SOC values. Each sample includes one or more voltage and/or SOC values based on the voltage sensing executed at multiple battery units.

Some examples of possible voltage values included in a given voltage sample are listed in TAB. 1 below.

TAB. 1: Example information content of a voltage sample. A voltage sample may include combinations of these examples. While TAB. 1 provides explanations for voltage samples, similar information content may be processed for SOC values, i.e., a minimum SOC, a maximum SOC, or an aggregate SOC.

| | VOLTAGE SAMPLE | DETAILS |
|---|---|---|
| 1 | Minimum voltage | The minimum voltage across all battery units in a sampling time interval can be reported by the voltage sample. For instance, consider a battery including n battery units, each providing a voltage value $V_i$ with $i = 1 \ldots n$. Then, the minimum voltage is $V_{min} := \min_{i=1\ldots n}(V_i)$ . |
| 2 | Maximum voltage | The maximum voltage across all battery units of the battery in a sampling time interval can be reported by the voltage sample. For instance, consider a battery including n units, each providing a voltage value $V_i$ with $i = 1 \ldots n$. Then, the maximum voltage is $V_{max} := \max_{i=1\ldots n}(V_i)$ . |
| 3 | Aggregate voltage | The aggregate voltage value is impacted by the voltage values of all battery units. For instance, the aggregate voltage value may be the average voltage value of all battery units in a sampling time interval: $V_{agg} := \frac{\sum_i V_i}{n}$ . In another scenario, the sum voltage $V_{agg} := \sum_i V_i$ is provided as the aggregate voltage. Further examples include median, etc. The output voltage of the battery may be provided as the aggregate voltage, $V_{agg} = V_{out}$. |

It is then possible to perform at least one analysis based on the voltage and/or SOC samples. Each analysis is based on a respective evolution of a respective characteristic of the one or more voltage and/or SOC values of the voltage and/or SOC samples. Thus, it can be considered how the respective characteristic changes over the course of the voltage and/or SOC samples.

More generally, an evolution may be defined in time domain. Here, time information associated with each voltage and/or SOC sample can be considered to define the time evolution of the respective voltage and/or SOC samples. The evolution is a function of time. An evolution may also be defined in the SOC domain, for voltage samples. Here, SOC information associated with each voltage sample can be considered to define the respective SOC evolution of the voltage samples. The evolution is a function of SOC.

Various techniques are based on the finding that such evolution of a characteristic of the one or more voltage and/or SOC values can be dependent on imbalances between the battery units. Thus, by considering the evolution (rather than a single voltage and/or SOC sample at a single time interval), it is possible to infer whether an imbalance is present. Optionally, it would be possible to quantify the imbalance. Sometimes, it would even be possible to determine a root cause of the imbalance. All such information may be retrieved from evolutions of characteristics of the voltage and/or SOC values (cf. TAB. 1) included in the voltage and/or SOC samples. Specifically, if compared to reference examples in which a single voltage and/or SOC spread at a given point in time is considered, extended information on root causes of the cell imbalances can be derived.

Various aspects of the disclosure are based on the finding that imbalances amongst battery units can occur even if and while the BMS executes a balancing process. For instance, certain imbalances may remain unnoticed by the BMS or the BMS may be unable to counteract or mitigate an imbalance. Thus, by implementing the imbalance monitoring based on one or more evolutions of one or more characteristics of the voltage and/or SOC values included in the voltage and/or SOC samples, it is possible - on application layer, e.g., in a cloud facility or a server - to introduce a second safety layer, in addition to a balancing protocol executed by the BMS.

In some scenarios, even for a successfully executed balancing process, it may be desirable to obtain information on the underlying root cause of the cell imbalance. Such information may not be available at BMS-level. For instance, depending on the root cause, different mitigation strategies may be chosen. For instance, certain root causes may be more severe than other root causes and may require the exchange of the battery pack including a battery cell that causes the cell imbalance.

Furthermore, it has been observed that not all BMSs provide an indication of a severity of the cell imbalance. For instance, sometimes a cell imbalance may be present that is comparatively weak, and no further action may be required. On the other hand, sometimes a relatively severe cell imbalance may be present and may limit, e.g., the maximum SOC. Then, a single weak battery cell, e.g., having progressed aging, limits the effectively usable capacity of the battery. Thus, based on an indication of the severity of the cell imbalance, it may sometimes be possible to judge whether exchange of a respective battery unit, e.g., by exchanging the battery pack, is required or not.

Hence, according to the disclosed techniques, it is possible to determine at least one indicator that is associated with such cell imbalance. This at least one indicator may be indicative of or comprise a root cause of the cell imbalance and/or a severity of the cell imbalance.

Based on such at least one indicator, it would be possible to control the BMS of the battery, e.g., to bypass one or more battery units. An exchange of a battery pack may be triggered. A shutdown of the battery can be triggered, to prevent damage. A balancing process of the BMS may be parametrized based on such at least one indicator.

Next, various examples will be described in further detail in connection with the drawings. In the drawings, reference will be primarily made to voltage-based reporting of the BMS, i.e., voltage samples including voltage values. However, similar techniques can be readily applied to other types of reporting, e.g., by determining a SOC based on the voltage value at the BMS and then reporting the SOC.

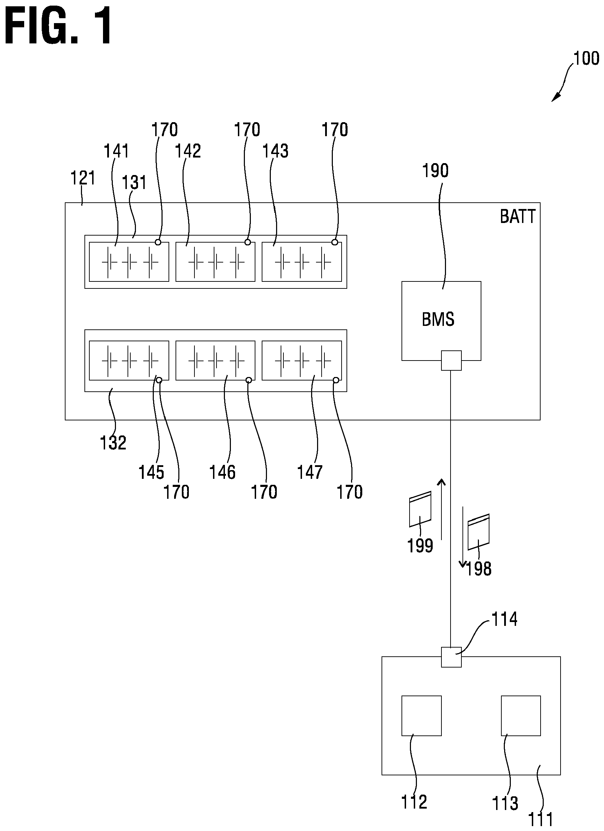

FIG. 1 schematically illustrates a system 100. The system 100 includes a battery 121. The battery 121 includes multiple battery packs 131, 132. A battery pack 131, 132 is the smallest replaceable entity. Each of the battery packs 131, 132 includes multiple battery units 141-143, 145-147. In the illustrated example, each of the battery units 141-143, 145-147 includes multiple battery cells; as a general rule, it would be possible that each battery unit only includes a single battery cell. Each battery unit 141-143, 145-147 has an associated voltage sensor 170 configured to measure the voltage of the respective one or more battery cells that are connected in series and/or in parallel within that battery unit.

The battery 121 also includes a BMS 190. The BMS 190 implements a voltage sensing process based on the voltage values measured at the voltage sensors 170. The BMS 190 executes a balancing process to balance the voltage values measured at the battery units 141-143, 145-147.

The BMS 190 also implements a reporting process. Reporting data 198 is provided to a processing device 111. The BMS 190, for this purpose, includes a communication interface 191 via which the reporting data 198 is transmitted to the processing device 111, e.g., via the Internet or a Local Area Network.

In particular, the BMS 190 provides voltage samples for a sequence of time intervals. Each voltage sample can include one or characteristic voltage values at the respective sampling interval. Details have been discussed above in connection with TAB. 1.

The processing device 111 includes at least one processor 112 and a memory 113. The processor 112 can receive the reporting data 198 via a communication interface 114 of the processing device 111. The processor 112 can load program code from the memory 113 and execute the program code. Based on such execution of the program code, the processor 112 can perform techniques as disclosed herein, e.g.: obtaining voltage samples, e.g., as part of the reporting data 198; process the reporting data 198, e.g., by performing at least one analysis of an evolution of a characteristic of one or more voltage values included in the voltage samples; control the battery 121, e.g., by providing, to the BMS 190, control data 199.

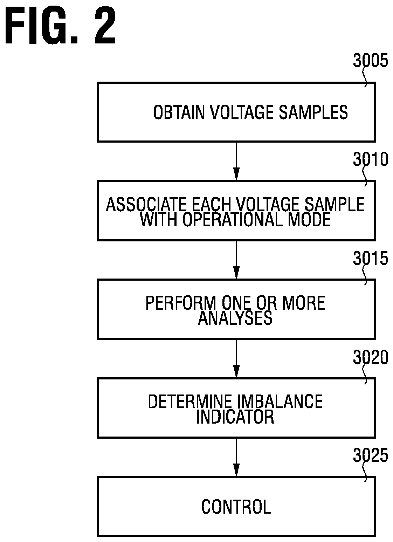

FIG. 2 is a flowchart of a method according to various examples. The method of FIG. 2 can be executed by a processing device such as the processing device 111 illustrated in FIG. 1. For instance, the method of FIG. 2 may be executed by the processor 112 upon loading program code from the memory 113 and upon executing the program code.

At box 3005, multiple voltage samples that are acquired by a BMS - e.g., the BMS 190 - are obtained. Each voltage sample is associated with a respective sampling interval. A time sequence of voltage samples can be obtained.

Box 3005 can include receiving reporting data such as the reporting data 198. The reporting data can be received from a BMS. The reporting data can be received via the Internet.

At box 3010, it is optionally possible to determine an association of each of the multiple voltage samples with a respective one of two or more operating modes of the battery unit. Example operating modes are idling and non-idling. In the idling operating mode, the current drawn from the battery cells is below a certain threshold.

I.e., the battery is not charged or discharged. In the non-idling operating mode, the battery is charged or discharged. Other operating modes would be conceivable, e.g., high temperature operating mode, reduced capability mode, charging mode, discharging mode, to give just a few examples.

At box 3015, at least one analysis is performed. Each analysis performed at box 3015 operates based on a respective at least one characteristic of at least some of the voltage values included in the voltage samples.

For instance, it would be possible that each analysis is operating based on a respective subset of only some of the voltage samples. This subset of voltage samples can be obtained based on filtering - prior to executing the respective analysis - the voltage samples based on the associations of box 3010. For instance, a first analysis may only consider those voltage samples associated with the non-idling operating mode; while a second analysis may only consider those voltage samples associated with the idling operating mode.

Each analysis thus considers at least one evolution - e.g., a time evolution and/or a SOC evolution - of at least one characteristic of the voltage values (cf. TAB. 1) included in the voltage samples. Some characteristics of the voltage values that can be subject to a respective analysis are listed in TAB. 2 below.

TAB. 2: Various characteristics of voltage values for which the respective evolution can be considered. Different characteristics can be considered as part of different analyses.

| | CHARACTERISTIC | DETAILS |
|---|---|---|
| 1 | Voltage spread | The evolution of the difference between the minimum voltage and the maximum voltage - cf. TAB. 1, examples 1 and 2 - can be considered: $\Delta V := V_{max} - Vmi, -$ |
| 2 | Change rate | The evolution of the time-domain change rate of one or more voltage values such as those listed in TAB. 1 can be considered: $dV_{max}/dt$; $dV_{min}/dt, dV_{agg}/dt$ The change rate quantifies the variation, in time domain, of a voltage value. |
| 3 | Identifiers of minimum and maximum voltage battery units | The evolution of identifiers $s$, $t$ of the battery units exhibiting the minimum voltage values and maximum voltage values, respectively can be considered, cf. TAB. 1, examples 1 and 2. $V_s = V_{min}$ mit $s \in \{1, ... , n\}$ und $V_t = V_{max}$ mit $t \in \{1, ... , n\}$ |

Then, based on the at least one analysis of box 3015, at box 3020, at least one indicator is determined. The at least one indicator is associated with a cell imbalance amongst the battery cells of the battery.

An indicator of the at least one indicator may include, e.g., whether an imbalance is present or not. A severity of the imbalance may be indicated. For instance, based on the severity of the imbalance it may be judged whether a shutdown of the battery is required or not and/or whether a battery pack is to be exchanged or not. The indicator may include a root cause of the imbalance. Example root causes include, but are not limited to: a malfunction of a sensor, e.g., a voltage sensor; self-discharging of at least one of the battery units; a malfunction of a cell-balancing protocol of the BMS; or unequal ageing of the cells of the battery units.

Further examples include thermal differences; pressure differences; etc.

At box 3025, it would be optionally possible to control the BMS of the battery based on the at least one indicator of box 3020. For instance, a shutdown may be triggered. Reduced maximum and/or minimum SOCs may be enforced.

As will be appreciated from the above, various characteristics of the voltage values included in the voltage samples can be considered. In addition, it is possible to consider such characteristics for voltage values in different operating modes. Next, further details with respect to such characteristics and the associated analyses that can reveal information associated with the cell imbalance are discussed.

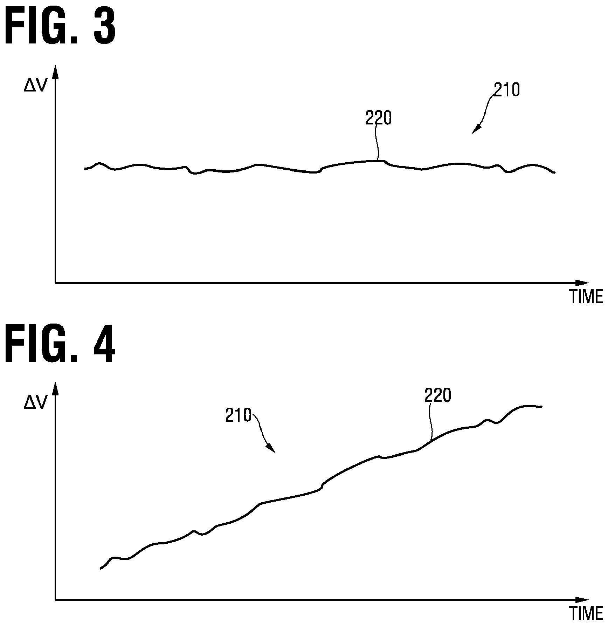

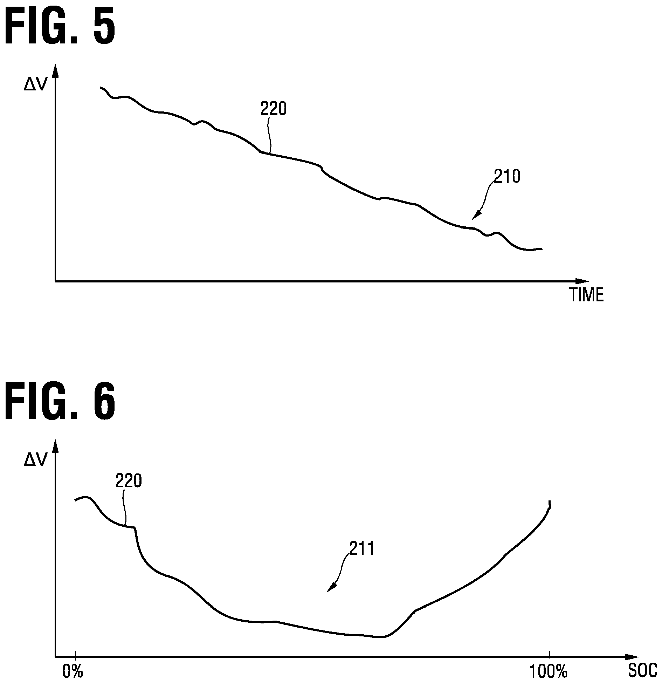

FIG. 3 illustrates the time evolution 210 of the voltage spread 220 in a first scenario, cf. TAB. 2, example 1. FIG. 4 illustrates the time evolution 210 of the voltage spread 220 in a second scenario, cf. TAB. 2, example 1. FIG. 5 illustrates the time evolution 210 of the voltage spread 220 in a third scenario, cf. TAB. 2, example 1. FIG. 6 illustrates the SOC evolution 211 of the voltage spread 220 in a fourth scenario, cf. TAB. 2, example 1. In the scenario FIG. 3, the voltage spread 220 stays relatively constant as a function of time. This is the desired behavior for zero or minimal cell imbalances. This is different in the scenario FIG. 4 in the scenario FIG. 5. Here, the voltage spread 220 increases (FIG. 4) and decreases (FIG. 5) as a function of time. In FIG. 6, the voltage spread 220 is plotted as a function of SOC. As illustrated, the voltage spread 220 takes relatively large values for small SOCs and large SOCs, but takes relative small values for medium SOCs. All scenarios of FIG. 3, FIG. 4, FIG. 5, and FIG. 6 may be observed in an idling operating mode and/or a non-idling operating mode.

The time evolution 210 and the SOC evolution 211 in the scenarios of FIG. 3, FIG. 4, FIG. 5, and FIG. 6 are based on the voltage spread 220. The voltage spread 220 is only one characteristic - cf. TAB. 2: example 1 - of the voltage values included in the voltage samples that can be subject to an analysis to infer the at least one indicator associated with the cell imbalance. Another option - cf. TAB. 2: example 2 - is the change rate of voltage values. This is discussed next.

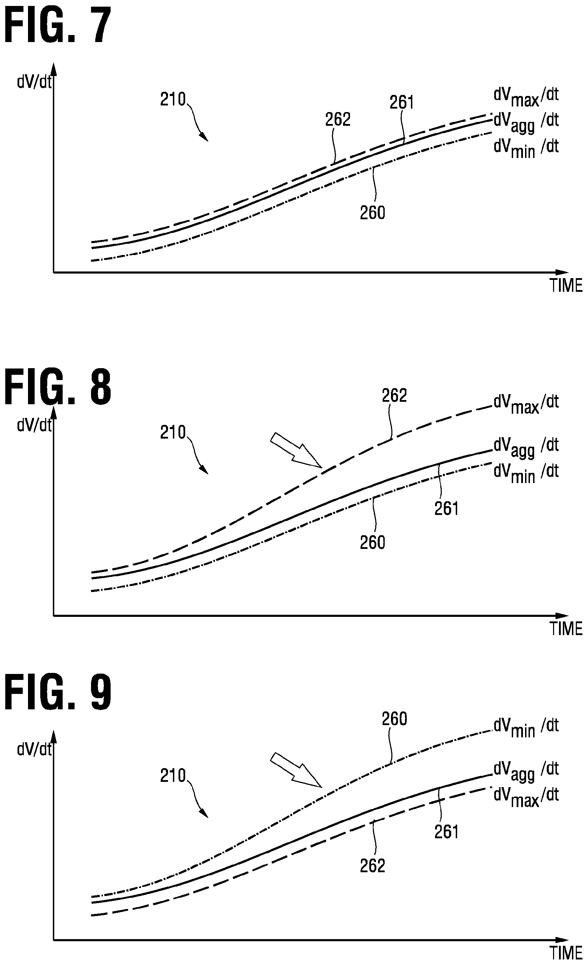

FIG. 7 illustrates the time evolution 210 of the change rate 260 of the minimum voltage value, of the change rate 261 of the aggregate voltage value, as well as of the change rate 262 of the maximum voltage value in a first scenario, cf. TAB. 2, example 2. FIG. 8 illustrates the time evolution 210 of the change rate 260 of the minimum voltage value, of the change rate 261 of the aggregate voltage value, as well as of the change rate 262 of the maximum voltage value in a second scenario, cf. TAB. 2, example 2. FIG. 9 illustrates the time evolution 210 of the change rate 260 of the minimum voltage value, of the change rate 261 of the aggregate voltage value, as well as of the change rate 262 of the maximum voltage value in a third scenario, cf. TAB. 2, example 2. In the second scenario of FIG. 8 and the third scenario of FIG. 9 there is an outlier change rate (labeled with the arrow), respectively: This outlier change rate shows a larger time dependency than the two other change rates; this is not the case in FIG. 7 which is the desired behavior for zero or minimal cell imbalances.

Other scenarios are conceivable in which the outlier change rate shows a smaller time dependency than the two other remaining change rates. All scenarios of FIG. 7, FIG. 8, and FIG. 9 may be observed in an idling operating mode and/or a non-idling operating mode.

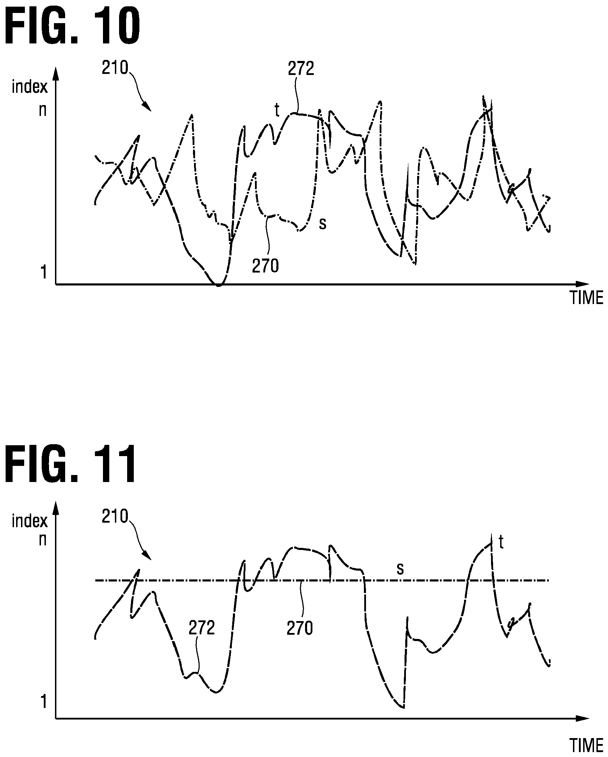

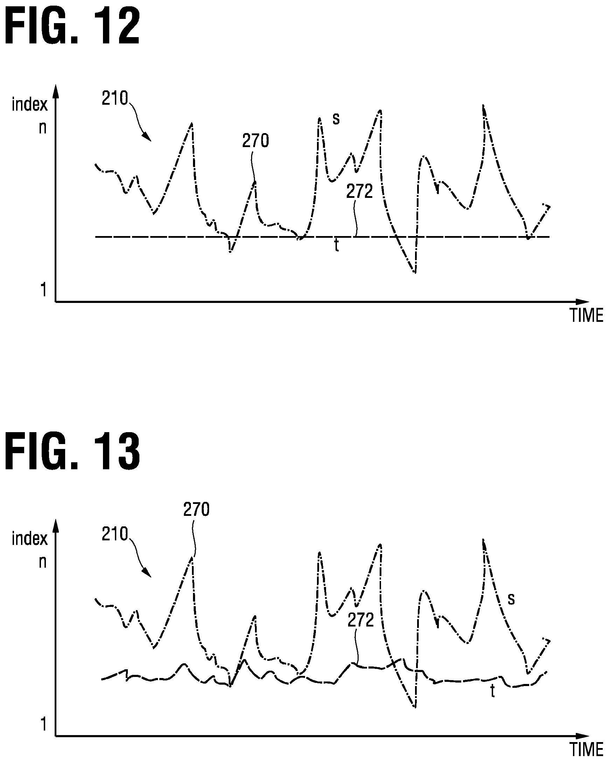

FIG. 10 illustrates the time evolution 210 of the indicator 270 of the battery unit exhibiting the minimum voltage value and the indicator 272 of the battery unit exhibiting the maximum voltage value in a first scenario, cf. TAB. 2, example 3. FIG. 11 illustrates the time evolution 210 of the indicator 270 of the battery unit exhibiting the minimum voltage value and the indicator 272 of the battery unit exhibiting the maximum voltage value in a second scenario, cf. TAB. 2, example 3. FIG. 12 illustrates the time evolution 210 of the indicator 270 of the battery unit exhibiting the minimum voltage value and the indicator 272 of the battery unit exhibiting the maximum voltage value in a third scenario, cf. TAB. 2, example 3. FIG. 13 illustrates the time evolution 210 of the indicator 270 of the battery unit exhibiting the minimum voltage value and the indicator 272 of the battery unit exhibiting the maximum voltage value in a fourth scenario, cf. TAB. 2, example 3.

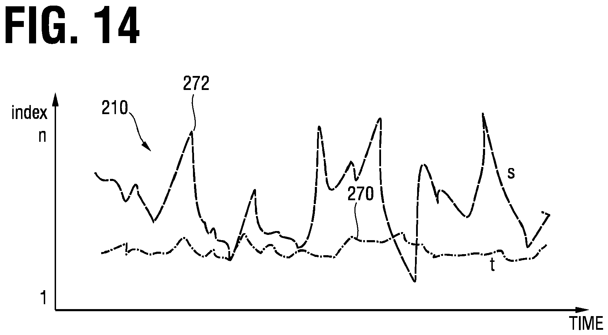

In the scenario of FIG. 10, the indicator 270 as as well as the indicator 272 both vary across substantially the entire dynamic range, i.e., from 1 ... n . This is the desired behavior for zero or minimal cell imbalances. This is different in the scenarios of FIG. 11, FIG. 12, and FIG. 13. Here, one of the indicators 270, 272 does not vary (FIG. 11, FIG. 12) or only varies within in a subrange of the dynamic range. For instance, in FIG. 13, the subrange within which the indicator 272 varies corresponds to all battery units of a given battery pack; thus, the maximum voltage is consistently observed for battery units of a given battery pack - other battery packs do not include battery units experiencing the maximum voltage. Similarly, in FIG. 14 the subrange within which the indicator 270 varies corresponds to all battery units of a given battery pack; thus, the minimum voltage is consistently observed for battery pack - other battery packs do not include battery units experiencing the minimum voltage. While the examples of FIG. 13 and FIG. 14 are at the level of battery packs, the subranges of the indicator 272 (in FIG. 13) and the indicator 270 (in FIG. 14) may also correspond to a battery module.

Various techniques are based on the finding that certain features or patterns observed in such evolutions 210, 211 discussed above can reveal the root cause and/or a severity of a cell imbalance. This may be agnostic of the particular operating state (e.g., the particular temperature). This may be agnostic of the cell chemistry. Thus, by analyzing such evolutions 210, 211 to match certain features, a reliable and versatile technique of imbalance monitoring is enabled. Some qualitative examples correlation between features of the evolutions and associated root causes and/or severities of the cell imbalance are discussed below.

A possible root cause is cell self-discharge. Cell self-discharge is best detected by considering a subset of all voltage samples associated with the idling operating mode. A typical fingerprint is a time evolution 210 of the voltage spread 220 (in the idling operating mode) as shown in the scenario illustrated in FIG. 4, i.e., an increase in voltage spread over time. The cell slowly discharges, thereby increasing the voltage spread. Sometimes scenarios are conceivable in which voltage sample in the idling operating mode are sparse or altogether unavailable. In particular, for BESS use cases, voltage samples in idling operating mode do not often occur due to the operation pattern of the BESS. Hence, it is desirable to also detect cell self-discharge by considering voltage samples associated with the non-idling operating mode. A typical fingerprint for the cell self-discharge root cause that is also available in the non-idling operating mode (in addition to being available in the idling operating mode) is an outlier time evolution of the change rate 260, 261, 262, e.g., as illustrated in the scenarios of FIG. 8 and FIG. 9 (outliers marked with arrows). Typically, the minimum voltage changes faster than the maximum and aggregate voltages (cf. FIG. 9). This fingerprint of the cell self-discharge root cause in the non-idling operating mode is typically accompanied by the time evolution 210 of the voltage spread according to the scenarios of FIG. 3 (i.e., the time evolution 210 of the voltage spread 220 is approximately stable) as well as FIG. 10 (i.e., the time evolution 210 of the indicator of the battery unit experienced a minimum voltage as well as the indicator 272 of the battery unit experiencing the maximum voltage changes across the entire dynamic range). This behavior is observed because of the cell-balancing protocol balancing the self-discharging cell during the non-idling operating mode: triggered by the self-discharging, the BMS re-charges the cell from time to time.

Another root cause is malfunctioning of the cell-balancing protocol executed by the BMS. Cell-balancing may not be operational at all; i.e., the BMS may not execute any cell-balancing. This root cause can be revealed based on considering subsets of voltage samples, either in the idling operating mode or in the non-idling operating mode. In many practical scenarios, filtering to only retain non-idling operating mode voltage samples is employed, since those voltage samples are available at a much higher time domain density than voltage samples associated with the idling operating mode. A typical fingerprint is a time evolution 210 of the indicators 270, 272 in which one of the min/max indicators 270, 272 does not change or does not change significantly. Respective scenarios have been illustrated in FIG. 11, FIG. 12, FIG. 13, and FIG. 14. This fingerprint can be accompanied by a time evolution 210 of the voltage spread 220 is illustrated in the scenario FIG. 4, i.e., an increase of the voltage spread 220 over time; and/or can accompanied by a time evolution 210 of the change rates 260, 261, 262 as shown in the scenario of FIG. 7 i.e., similar change rates 260, 261, 262 for the minimum voltage values, the maximum voltage values, as well as the aggregated voltage values (no outlier change rate). For instance, in a scenario as illustrated in FIG. 13 or FIG. 14, the limited dynamic range of the indicators 270, 272, respectively, may be correlated with the malfunctioning of the cell-balancing protocol restricted to that respective battery pack or battery module. For other battery packs or modules, the cell-balancing protocol may operate correctly. This may be further rooted in a software problem. A software update or fix updating the respective program code executed by the BMS to provide the cell-balancing protocol may be helpful to fix that issue. However, the scenarios of FIG. 11 and FIG. 12 are less likely fixable by a software update; here, a replacement for the cell indicates by the static indicator 270, 272 may be required.

Yet a further root cause is a particular weak battery cell in a battery unit. For such a battery cell, capacity degradation and/or impedance increase due to aging can have progressed beyond a predetermined threshold. Thus, a particular severe imbalance may result. Atypical fingerprint is a time evolution 210 of the indicators 270, 272 in which at least one of the min/max indicators 270, 272 (typically the min indicator 270) does not change or does not change significantly, cf. FIG. 11, FIG. 12, FIG. 13, and FIG. 14. This indicator points to the weak cell. This fingerprint is similar to the fingerprint discussed above in connection with the root cause of the cell-balancing protocol malfunctioning. To resolve ambiguities between the two root causes weak battery cell and cell-balancing protocol malfunctioning, it is possible consider multiple analyses that are based on different characteristics. Specifically, characteristic to a weak cell root cause is a SOC evolution 211 of the voltage spread 220 as illustrated in the scenario of FIG. 6. Here, a relatively high voltage spread 220 is observed at small and large SOC values, respectively; while at medium SOC values, a small voltage spread 220 is observed. The weak cell may be bypassed by the balancing protocol so that the voltage spread 220 increases; this differentiates against the malfunctioning root cause where balancing is not executed, thus the U-shaped SOC evolution 211 of the voltage spread 220 is not observed if the BMS balancing protocol is suspended/malfunctioning.

As will be appreciated from the above, by considering the results of multiple analyses considering different characteristics, it is possible to discriminate between different root causes - in the explained case the root cause of the cell-balancing protocol malfunctioning on the one hand, and the weak battery cell on the other hand.

This concept of considering multiple analysis that operate based on different characteristics to discriminate between different root causes or different severities of the cell imbalance can be applied to further scenarios. For instance, for the root cause of a sensor issue, i.e., a voltage sense of a battery unit that is malfunctioning, likewise, a discrimination can be made against the other root causes by considering the results of multiple analyses. This is explained next.

In the case of a sensor issue, similar to the previously discussed root causes of a malfunctioning balancing protocol and the root cause of the weak cell, the typical fingerprint is a time evolution 210 of the indicators 270, 272 in which one of the min/max indicators 270, 272 does not change or does not change significantly. For instance, a corrupt voltage sensor may provide an excessively large or excessively small voltage value for a given battery unit. Then, the min/max indicators 270, 272 are stuck to that value. Different to the other root causes discussed above, for a voltage sensor malfunctioning, a time evolution 210 of the change rates 260, 261, 262 as illustrated in one of the scenarios in FIG. 8 or FIG. 9 is expected. The change rate of either the minimum or maximum voltage value (depending on the particular nature of the voltage sensor fault), is approximately zero and thus deviates from the other change rates that are not affected or less severely affected by the faulty voltage sensor. A further fingerprint that may be helpful to reveal the sensor issue is an irregularly (e.g., randomly) varying voltage spread. Since other cells provide reliable and accurate voltage values, the voltage spread is sometimes small and sometimes large; but there is no clear dependency the voltage spread, i.e., the voltage spread is not continuously increasing or decreasing.

TAB. 3: summary of the expected features of the evolutions of the various characteristics for the various cell imbalance root cases, as well as for a system without significant imbalance and properly working balancing protocol.

| | Voltage imbalance | | Change rate | | Min/max indicators | |
|---|---|---|---|---|---|---|
| | Idle | Non-idle | Idle | Non-idle | Idle | Non-idle |
| Weak cell | U-shape spread (FIG. 6) | U-shape spread (FIG. 6) | no outlier (FIG. 7) | no outlier (FIG. 7) | Min identifier constant (FIG. 11) | Min identifier constant (FIG. 11) |

(continued)

|  | Voltage imbalance | | Change rate | | Min/max indicators | |
| --- | --- | --- | --- | --- | --- | --- |
|  | Idle | Non-idle | Idle | Non-idle | Idle | Non-idle |
| Failed Balancing | increase (FIG. 4) | increase (FIG. 4) | no outlier (FIG. 7) | no outlier (FIG. 7) | Max identifier constant (FIG. 12, FIG. 13) | Max identifier constant (FIG. 12, FIG. 13) |
| Self-discharge | increase (FIG. 4) | Const (FIG. 3) | Min voltage is outlier (FIG. 9) | Min voltage is outlier (FIG. 9) | Min identifier constant (FIG. 11) | full dynamic range (FIG. 10) |
| Sensor malfunct. | Const (FIG. 3) | Const (FIG. 3) | no outlier (FIG. 7) | no outlier (FIG. 7) | reduced range (FIG. 11, FIG. 12, FIG. 13) | reduced range (FIG. 11, FIG. 12, FIG. 13) |
| all working | decrease (FIG. 5) | no specific pattern | Max voltage is outlier (FIG. 8) | no outlier (FIG. 7) | full dynamic range (FIG. 10) | full dynamic range (FIG. 10) |

Summarizing, at least the following EXAMPLES have been disclosed.

EXAMPLE 1. A method, comprising:

- obtaining (3005) multiple samples, each sample of the multiple samples comprising one or more values acquired by a battery management system (190) of a battery (121) based on voltage sensing (170) at multiple battery units (141, 142, 143, 145, 146, 147),
- performing (3015) at least one analysis, each of the at least one analysis being based on a respective at least one evolution (210, 211) of a respective at least one characteristic (220, 260, 261, 262, 270, 272) of the one or more values, and
- based on a result of the at least one analysis, determining (3020) at least one indicator associated with a cell imbalance of battery cells of the battery units (141, 142, 143, 145, 146, 147).

EXAMPLE 2. The method of EXAMPLE 1,

wherein the one or more values comprise a minimum value of the multiple battery units (141, 142, 143, 145, 146, 147) and a maximum value of the multiple battery units (141, 142, 143, 145, 146, 147),
wherein the at least one characteristic of a respective analysis of the at least one analysis comprises a spread (220) between the minimum value and the maximum value.

EXAMPLE 3. The method of EXAMPLE 1 or 2,
wherein the at least one characteristic of a respective analysis of the at least one analysis comprises at least one change rate (260, 261, 262) of the one or more values.

EXAMPLE 4. The method of EXAMPLE 3,

wherein the one or more values comprise a minimum value of the multiple battery units and a maximum value of the multiple battery units and an aggregate value of all battery units,
wherein a first characteristic of the at least one characteristic of the respective analysis comprises a first change rate (260) of the minimum value,
wherein a second characteristic of the at least one characteristic of the respective analysis comprises a second change rate (262) of the maximum value,
wherein a third characteristic of the at least one characteristic of the respective analysis comprises a third change rate (161) of the aggregate value.

EXAMPLE 5. The method of EXAMPLE 4,
wherein the respective analysis determines whether an outlier is present amongst a first evolution of the first characteristic, a second evolution of the second characteristic, and a third evolution of the third characteristic.

EXAMPLE 6. The method of any one of the preceding EXAMPLEs,

wherein the one or more values comprise a minimum value of the multiple battery units (141, 142, 143, 145, 146, 147) and a maximum value of the multiple battery units (141, 142, 143, 145, 146, 147),

wherein the at least one characteristic of a respective analysis of the at least one analysis is based on at least one identifier (270, 272) identifying the battery unit (141, 142, 143, 145, 146, 147) respectively associated with at least one of the minimum value or the maximum value.

EXAMPLE 7.The method of any one of the preceding EXAMPLEs, further comprising:

- for each of the multiple samples: determining (3010) an association of the respective sample with a respective one of two or more operating modes of the battery (121), and
- for each of the at least one analysis: filtering the multiple samples depending on the associations before executing the respective analysis.

EXAMPLE 8.The method of EXAMPLE 7,
wherein the two or more operating modes comprise an idling operating mode and a non-idling operating mode.

EXAMPLE 9.The method of any one of the preceding EXAMPLEs,
wherein the respective at least one evolution of a given analysis of the at least one analysis is a function of a state of charge or a function of time.

EXAMPLE 10. The method of any one of the preceding EXAMPLEs,
wherein the at least one indicator comprises a root cause of the imbalance.

EXAMPLE 11. The method of EXAMPLE 10,
wherein the root cause is selected from a group comprising: a malfunctioning of a sensor of the battery, a self-discharging of at least one of the battery units, a malfunctioning of a cell-balancing protocol executed by the battery management system, or at least one of the battery units having relatively progressed ageing.

EXAMPLE 12. The method of any one of the preceding EXAMPLEs,
wherein the at least one indicator comprises a severity of the imbalance.

EXAMPLE 13. The method of any one of the preceding EXAMPLEs,

wherein the at least one analysis comprises multiple analyses,
wherein the at least one indicator is determined based on the results of the multiple analyses.

EXAMPLE 14. The method of any one of the preceding EXAMPLEs,

wherein the one or more values comprise a minimum value of the multiple battery units and a maximum value of the multiple battery units and an aggregate value of all battery units,
wherein a first characteristic of a given analysis is based on a first change rate (260) of the minimum value in a non-idling operating mode or an idling operating mode of the battery,
wherein a second characteristic of the given analysis is based on a second change rate (262) of the maximum value in the non-idling operating mode or the idling operating mode of the battery,
wherein a third characteristic of the given analysis is based on a third change rate (261) of the aggregate value in the non-idling operating mode or the idling operating mode of the battery,
wherein the method further comprises:

- upon detecting a first evolution of first change rate (261) as a function of time as an outlier if compared to a second evolution (210) of the second change rate (262) as a function of time and to a third evolution (210) of the third change rate (261) as a function of time, determining the at least one indicator to be indicative of a self-discharging of at least one of the battery units.

EXAMPLE 15. The method of any one of the preceding EXAMPLEs,

wherein the one or more values comprise a minimum value of the multiple battery units and a maximum value of the multiple battery units,
wherein a given characteristic of a given analysis is based on an identifier identifying the battery units respectively associated with the maximum value,
wherein the method further comprises:

- upon detecting that the respective evolution, as a function of time, of the given characteristic has a variation below a predetermined threshold, determining the at least one indicator to be indicative of a malfunctioning of a cell-balancing protocol executed by the battery management system.

EXAMPLE 16. The method of any one of the preceding EXAMPLEs,

wherein the one or more values comprise a minimum value of the multiple battery units and a maximum value of the multiple battery units,
wherein a given characteristic of a given analysis is based on a voltage spread between the minimum value and the maximum value,
wherein the method further comprises:

- upon detecting that the respective evolution of the given characteristic has a U-shape as a function of state of charge, determining the at least one indicator to be indicative of a weak cell.

EXAMPLE 17. The method of any one of the preceding EXAMPLEs,
wherein the one or more values are voltage values or state-of-charge values.

EXAMPLE 18. A processing device (111) comprising a processor (112), the processor being configured to load program code from a memory and to execute the program code, the processor, based loading and executing the program code being configured to:

- obtain (3005) multiple samples, each sample of the multiple samples comprising one or more values acquired by a battery management system (190) of a battery (121) based on voltage sensing (170) at multiple battery units (141, 142, 143, 145, 146, 147),
- perform (3015) at least one analysis, each of the at least one analysis being based on a respective at least one evolution (210, 211) of a respective at least one characteristic (220, 260, 261, 262, 270, 272) of the one or more values, and
- based on a result of the at least one analysis, determine (3020) at least one indicator associated with a cell imbalance of battery cells of the battery units (141, 142, 143, 145, 146, 147).

EXAMPLE 19. The processing device of EXAMPLE 18, wherein the processor is configured to execute the method of any one of EXAMPLEs 1 to 16.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For illustration, above scenarios have been disclosed in which voltage samples include a minimum voltage value and a maximum voltage value across the battery units for which voltage sensing is enabled. Similar techniques may be implemented for other types of reporting content. For instance, the voltage samples may include a first processed voltage value that is determined as the average of the 10% lowest voltage values may include a second processed voltage value that is determined based on the average of the 10% highest voltage values, to give only one example.

For further illustration, various specific types of root causes of cell imbalances have been discussed above. The techniques disclosed herein are not limited to such root causes. Other root causes are conceivable. Further root causes may include, e.g., thermal gradients amongst battery units, e.g., due to malfunctioning of the active thermal stabilization, etc.

For still further illustration, above various scenarios have been disclosed in which voltage values are obtained as part of voltage samples. However, it would be equally possible to obtain SOC values that are included in SOC samples.

**Claims**

1.  A method, comprising:

    - obtaining (3005) multiple samples, each sample of the multiple samples comprising one or more values acquired by a battery management system (190) of a battery (121) based on voltage sensing (170) at multiple battery units (141, 142, 143, 145, 146, 147),
    - performing (3015) at least one analysis, each of the at least one analysis being based on a respective at least one evolution (210, 211) of a respective at least one characteristic (220, 260, 261, 262, 270, 272) of the one or more values, and
    - based on a result of the at least one analysis, determining (3020) at least one indicator associated with a cell imbalance of battery cells of the battery units (141, 142, 143, 145, 146, 147).

2.  The method of claim 1,

wherein the one or more values comprise a minimum value of the multiple battery units (141, 142, 143, 145, 146, 147) and a maximum value of the multiple battery units (141, 142, 143, 145, 146, 147),

wherein the at least one characteristic of a respective analysis of the at least one analysis comprises a spread (220) between the minimum value and the maximum value.

3.  The method of claim 1 or 2,

wherein the at least one characteristic of a respective analysis of the at least one analysis comprises at least one change rate (260, 261, 262) of the one or more values.

4.  The method of claim 3,

wherein the one or more values comprise a minimum value of the multiple battery units and a maximum value of the multiple battery units and an aggregate value of all battery units,

wherein a first characteristic of the at least one characteristic of the respective analysis comprises a first change rate (260) of the minimum value,

wherein a second characteristic of the at least one characteristic of the respective analysis comprises a second change rate (262) of the maximum value,

wherein a third characteristic of the at least one characteristic of the respective analysis comprises a third change rate (161) of the aggregate value.

5.  The method of claim 4,

wherein the respective analysis determines whether an outlier is present amongst a first evolution of the first characteristic, a second evolution of the second characteristic, and a third evolution of the third characteristic.

6.  The method of any one of the preceding claims,

wherein the one or more values comprise a minimum value of the multiple battery units (141, 142, 143, 145, 146, 147) and a maximum value of the multiple battery units (141, 142, 143, 145, 146, 147),

wherein the at least one characteristic of a respective analysis of the at least one analysis is based on at least one identifier (270, 272) identifying the battery unit (141, 142, 143, 145, 146, 147) respectively associated with at least one of the minimum value or the maximum value.

7.  The method of any one of the preceding claims, further comprising:

- for each of the multiple samples: determining (3010) an association of the respective sample with a respective one of two or more operating modes of the battery (121), and

- for each of the at least one analysis: filtering the multiple samples depending on the associations before executing the respective analysis.

8.  The method of claim 7,

wherein the two or more operating modes comprise an idling operating mode and a non-idling operating mode.

9.  The method of any one of the preceding claims,

wherein the respective at least one evolution of a given analysis of the at least one analysis is a function of a state of charge or a function of time.

10. The method of any one of the preceding claims,

wherein the at least one indicator comprises a root cause of the imbalance.

11. The method of claim 10,

wherein the root cause is selected from a group comprising: a malfunctioning of a sensor of the battery, a self-discharging of at least one of the battery units, a malfunctioning of a cell-balancing protocol executed by the battery management system, or at least one of the battery units having relatively progressed ageing.

12. The method of any one of the preceding claims,

wherein the at least one indicator comprises a severity of the imbalance.

13. The method of any one of the preceding claims,

wherein the at least one analysis comprises multiple analyses,
wherein the at least one indicator is determined based on the results of the multiple analyses.

14. A processing device (111) comprising a processor (112), the processor being configured to load program code from a memory and to execute the program code, the processor, based loading and executing the program code being configured to:

   - obtain (3005) multiple samples, each sample of the multiple samples comprising one or more values acquired by a battery management system (190) of a battery (121) based on voltage sensing (170) at multiple battery units (141, 142, 143, 145, 146, 147),
   - perform (3015) at least one analysis, each of the at least one analysis being based on a respective at least one evolution (210, 211) of a respective at least one characteristic (220, 260, 261, 262, 270, 272) of the one or more values, and
   - based on a result of the at least one analysis, determine (3020) at least one indicator associated with a cell imbalance of battery cells of the battery units (141, 142, 143, 145, 146, 147).

15. The processing device of claim 14, wherein the processor is configured to execute the method of any one of claims 1 to 13.

# FIG. 1

# FIG. 2

3005
```
┌─────────────────────────────────────┐
│       OBTAIN VOLTAGE SAMPLES         │
└─────────────────────────────────────┘
                   │
                   ▼
```
3010
```
┌─────────────────────────────────────┐
│   ASSOCIATE EACH VOLTAGE SAMPLE      │
│     WITH OPERATIONAL MODE            │
└─────────────────────────────────────┘
                   │
                   ▼
```
3015
```
┌─────────────────────────────────────┐
│       PERFORM ONE OR MORE            │
│            ANALYSES                  │
└─────────────────────────────────────┘
                   │
                   ▼
```
3020
```
┌─────────────────────────────────────┐
│       DETERMINE IMBALANCE            │
│            INDICATOR                 │
└─────────────────────────────────────┘
                   │
                   ▼
```
3025
```
┌─────────────────────────────────────┐
│              CONTROL                 │
└─────────────────────────────────────┘
```

# FIG. 3

# FIG. 4

# FIG. 5

# FIG. 6

# FIG. 7

# FIG. 8

# FIG. 9

# FIG. 10

# FIG. 11

# FIG. 12

index
n

210

270

s

272

t

1

TIME

# FIG. 13

270

index
n

210

s

272

t

1

TIME

# FIG. 14

Europäisches
Patentamt

European
Patent Office

Office européen
des brevets

# EUROPEAN SEARCH REPORT

**Application Number**

EP 24 16 3856

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 677 465 A1 (BYD CO LTD [CN]) 8 July 2020 (2020-07-08) * paragraph [0019] - paragraph [0045]; figures 1-5; table 1 * | 1-15 | INV. H02J7/00 G01R31/3835 G01R31/388 G01R31/396 |
| X | EP 2 083 494 B1 (PANASONIC CORP [JP]) 8 August 2012 (2012-08-08) | 1-6,9-15 | H01M10/42 |
| A | * paragraph [0021] - paragraph [0022] * * paragraph [0055] - paragraph [0097]; figures 1,5-8 * | 7,8 | |
| X | US 11 721 847 B1 (HOM LEWIS ROMEO [US] ET AL) 8 August 2023 (2023-08-08) | 1-6,9-15 | |
| A | * column 2, line 20 - line 37 * * column 3, line 4 - line 65; figures 1,2 * * column 5, line 34 - column 8, line 39; claims 1-4,11-14; figures 4-9 * | 7,8 | |
| X | WO 2009/146048 A1 (A123 SYSTEMS INC [US]; HOFF C MICHAEL [US]) 3 December 2009 (2009-12-03) | 1-6, 9-11, 13-15 | |
| A | * paragraph [0011] - paragraph [0012] * * paragraph [0039] - paragraph [0053]; figures 1a-5 * | 7,8,12 | **TECHNICAL FIELDS SEARCHED (IPC)** H02J G01R |

The present search report has been drawn up for all claims

| Place of search | Date of completion of the search | Examiner |
|---|---|---|
| Munich | 8 August 2024 | Mäki-Mantila, Harri |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 3856

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2024

| Patent document cited in search report | | Publication date | Patent family member(s) | | Publication date |
|---|---|---|---|---|---|
| EP 3677465 | A1 | 08-07-2020 | CN | 110015185 A | 16-07-2019 |
| | | | EP | 3677465 A1 | 08-07-2020 |
| | | | US | 2020346558 A1 | 05-11-2020 |
| | | | WO | 2019042398 A1 | 07-03-2019 |
| EP 2083494 | B1 | 08-08-2012 | CN | 101536285 A | 16-09-2009 |
| | | | EP | 2083494 A1 | 29-07-2009 |
| | | | JP | 5248764 B2 | 31-07-2013 |
| | | | JP | 2008118777 A | 22-05-2008 |
| | | | US | 2010066379 A1 | 18-03-2010 |
| | | | WO | 2008053969 A1 | 08-05-2008 |
| US 11721847 | B1 | 08-08-2023 | US | 10522881 B1 | 31-12-2019 |
| | | | US | 11217833 B1 | 04-01-2022 |
| | | | US | 11721847 B1 | 08-08-2023 |
| WO 2009146048 | A1 | 03-12-2009 | BR | PI0910105 A2 | 15-12-2015 |
| | | | CA | 2720231 A1 | 03-12-2009 |
| | | | CN | 102027655 A | 20-04-2011 |
| | | | EP | 2272148 A1 | 12-01-2011 |
| | | | JP | 2011520408 A | 14-07-2011 |
| | | | JP | 2015073429 A | 16-04-2015 |
| | | | KR | 20100131002 A | 14-12-2010 |
| | | | US | 2009243548 A1 | 01-10-2009 |
| | | | WO | 2009146048 A1 | 03-12-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120139547 A1

- US 11513164 B2